Europäisches Patentamt

(19) European Patent Office

Office européen des brevets

(11) Publication number: **0 171 801**
A2

(12) # EUROPEAN PATENT APPLICATION

(21) Application number: **85110199.8**

(22) Date of filing: **14.08.85**

(51) Int. Cl.⁴: **H 01 L 21/58**
**H 01 L 27/14**

(30) Priority: **17.08.84 US 641615**

(43) Date of publication of application:
**19.02.86 Bulletin 86/8**

(84) Designated Contracting States:
**DE FR GB**

(71) Applicant: HONEYWELL INC.
Honeywell Plaza
Minneapolis Minnesota 55408(US)

(72) Inventor: Marciniec, John W.
1A Keith Circle
Woburn Massachusetts 01801(US)

(72) Inventor: Cochran, Bruce C.
42 Reed Street
Lexington Massachusetts 02173(US)

(72) Inventor: Hartley, Martha A.
1222 Mammoth Road
Dracut Massachusetts 01826(US)

(74) Representative: Herzbach, Dieter et al,
Honeywell Europe S.A. Holding KG Patent- und
Lizenzabteilung Kaiserleistrasse 55 Postfach 184
D-6050 Offenbach am Main(DE)

(54) **Method for processing a backside illuminated detector assembly.**

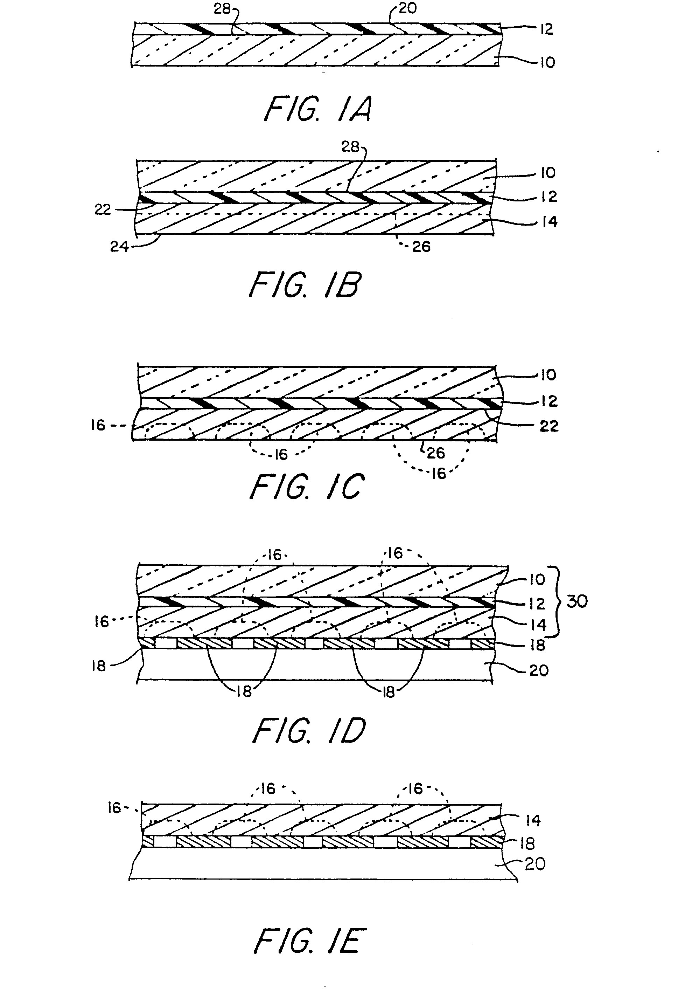

(57) A process for fabricating high performance backside illuminated detectors (10) is described. The process uses a transmissive adhesive (12) such as epoxy on a transmissive substrate (10) to hold the detector material (14) during the fabrication process. After fabrication and connection to a readout device (20), such as a CCD, the substrate (10) and adhesive (12) are removed using an appropriate solvent, leaving the thin detector assembly (14, 16), without extraneous material, mounted directly on the CCD (20). The process may be used for a variety of detector materials (Figures 1A to 1E).

FIG. 1A

FIG. 1E

HONEYWELL INC.
Honeywell Plaza
Minneapolis, Minn. 55440
USA

August 13, 1985
A3210809 EP
Hz/ep

Method for processing a backside illuminated detector assembly

The present invention relates to a method for processing a backside illuminated detector assembly according to the preamble of claim 1.

Infrared detection devices frequently utilize backside illuminated detector array assemblies. These assemblies are generally fabricated by permanently affixing the detector semiconductor material, such as mercury cadmium telluride (HgCdTe), to a transmissive substrate using an outgassed transmissive epoxy or other permanent adhesive. Once the semiconductor material is attached, detector arrays are fabricated by lapping and polishing the material to the desired thickness, then delineating the individual detector arrays using ion beam milling, photoresist, or some other well-known process. Thus, the finished assembly consists of a very thin detector assembly mounted to a transmissive substrate by a transmissive epoxy, and the detectors are illuminated through the window substrate and epoxy from the "backside." A charge coupled device (CCD) or other readout device is mounted on the open face of the detector assembly.

This process has several disadvantages. First, the use of the permanent substrate and adhesive result in a significant absorption of detectable radiation which reduces system performance. Second, the thermal mass of the substrate may be prohibitively high, particularly where it is desired to manufacture a pyroelectric detector assembly.

It is, accordingly, a primary object of the present invention to provide an improved method for fabricating backside illuminated detector assemblies which have reduced thermal mass and increased performance characteristics.

This object is achieved according to the characterizing features of claim 1. Further advantageous steps of the inventive method may be taken from the sub-claims.

The above and other objects of the present invention are achieved by mounting the detector material to a substrate using a soluble outgassed temporary adhesive which ideally is resistant to solvents used in the detector fabrication process. The detector material may then be processed to form detectors in the normal fashion. A transmissive substrate may be used to facilitate alignment of the detector assembly on the CCD or readout device. After attachment to the readout device, the substrate is removed using an appropriate solvent or by heating. The result is a low thermal mass detector which does not suffer the transmission losses which result from use of a window substrate in combination with a transmissive epoxy.

0171801

The above and other objects of the present invention are achieved in the illustrative embodiments as described with respect to the Figures in which:

Figures 1A, 1B, 1C, 1D and 1E show in cross-section successive stages of the method of fabrication of the present invention.

Referring to Figure 1E, the method of the present invention produces a finished backside illuminated detector assembly which has reduced thermal mass and improved performance because of the elimination of the transmissive substrate and absorbing permanent adhesive generally used in these assemblies. As shown in Figure 1A, a transmissive substrate 10 is prepared for fabrication in the same manner as in traditional backside illuminated fabrication techniques. A transmissive removable adhesive 12 is applied to surface 28 of substrate 10 to form a thin film approximately the dimension of the detector wafer 14 to be applied.

The substrate 10 may be made from any number of transmissive and inert materials, for example, glass, quartz, alumina or sapphire. The adhesive may be any removable adhesive, ideally not soluble in the solvents used in the detector delineation and fabrication process. For example, glycol phthalate (a wax) may be used, which is not soluble in trichloroethylene, but is soluble in acetone, methyl or isopropyl alcohol. In the case of glycol phthalate, the edges of the detector material are sealed to prevent the wax from dissolving in the process chemicals.

In the case of gylcol phthalate, adhesive 12 may be spread onto substrate 10 at approximately 70°C, and outgassed to remove trapped gases at approximately 130°C. Detector wafer 14 is cleaned and marked with alignment "streets" on surface 22 using well-known cleaning, polishing and photolithographic techniques. As shown in Figure 1B, cleaned detector wafer 14 is attached to substrate 10 using adhesive 12. Using glycol phthalate, this may be accomplished by placing detector wafer 14 with surface 22 facing up on an optical flat positioned on a hot plate (not shown), followed by placing substrate 10 with adhesive 12 face down on surface 22, and then placing a second weighted optical flat (not shown) on top of substrate 10 while on the hot plate. The entire assembly may be heated to an intermediate temperature, for example 65°C, for fifteen minutes in order to effect partial liquification and adhesion of layer 12 to both detector wafer 14 and substrate 10.

The addition of the optical flats and weight are not critical, but helps to ensure both the parallelism of all layers as well as the development of good adhesion between layers. It is understood that the time and temperature might be varied depending on the adhesive used, and the thickness of layer 12 desired.

As shown in Figure 1C, the detectors are then fabricated from wafer 14 by well-known processes, which may include, for example, polishing the entire assembly to final thickness (as shown by surface 26), forming individual detector elements 16 and dicing intermediate detector assemblies, as would be done using traditional backside illuminated detector fabrication processes.

With substrate 10 attached to detector elements 16, the completed detector assembly 30 may be attached to a CCD 20 or other readout device using well-known bump contact 18 methodology, as shown in Figure 1D. Substrate 10 and adhesive 12 may then be removed using an appropriate solvent, for example acetone, leaving a low thermal mass, high performance detector assembly, as shown in Figure 1E.

- 6 -

0171801

Claims:

1. A method for processing a backside illuminated detector assembly to be fabricated from a detector substrate having a first surface, c h a r a c t e r i z e d  b y  the following steps:

a) preparing a substantially transmissive planar substrate (10), said transmissive substrate having substantially parallel first and second surfaces;

b) applying a substantially transmissive removable adhesive layer (12) to said first surface of said transmissive substrate;

c) affixing said detector substrate (14) to said transmissive substrate by bringing said detector substrate into physical contact with said adhesive layer in a manner to cause adhesion between said transmissive substrate and said detector substrate;

d) fabricating detector elements (16) from said detector substrate;

e) attaching said detector elements to a detector readout device (20); and

f) removing said transmissive substrate (10) and said adhesive layer (12) thereby leaving said detector elements (16) positioned on said detector readout device (20).

2. A method according to claim 1, c h a r a c t e r i z e d i n  t h a t  said step of applying causes the removal of trapped gases from said first surface of said transmissive substrate (10) and from said removable adhesive layer (12).

3. A method according to claim 1, c h a r a c t e r i z e d i n  t h a t  said step of applying causes said first surface of said detector substrate (14) and said first surface of transmissive substrate (10) to be substantially parallel.

4. A method according to claim 1, c h a r a c t e r i z e d i n  t h a t  said removable adhesive (12) is insoluble in the solvents used in said step of fabricating said
detector elements (16).

5. A method according to claim 1, c h a r a c t e r i z e d
i n   t h a t   said substantially transmissive removable
adhesive (12) comprises glycol phthalate.

6. A method according to claim 5, c h a r a c t e r i z e d
i n   t h a t   said glycol pthalate is applied to said
first surface of said transmissive substrate (10) at
approximately 70°C.

7. A method according to claims 2 and 5, c h a r a c t e r -
i z e d   i n   t h a t   said removal of trapped gases
from said removable adhesive layer (12) and said transmissive substrate (10) is accomplished by heating and out-
gassing said transmissive substrate and said adhesive layer
at approximately 130°C.

8. A method according to claim 5, c h a r a c t e r i z e d
i n   t h a t   said step of removing said transmissive
window is accomplished using acetone.

9. A method according to claim 1, c h a r a c t e r i z e d
i n   t h a t   said step of affixing comprises the steps
of:
a) placing said detector substrate (14) on a heat source
   with said first surface facing away from said heat source;
b) placing said transmissive substrate (10) with said
   adhesive layer (12) on said first surface of said
   detector substrate (14);
c) placing a weighted substantially flat surface on top of
   said transmissive substrate (10) in order to insure
   proper adhesion of said transmissive substrate and said
   detector substrate (14); and
d) heating said detector substrate adhesive layer (12) and
   said transmissive substrate (10) in order to effect
   partial liquification and adhesion of said adhesive

- 8 -

0171801

layer (12) to both said transmissive substrate (10) and said detector substrate (14).

10. A method according to claim 9, c h a r a c t e r i z e d i n t h a t said step of heating is to approximately 65°C for approximately fifteen minutes.

11. A method according to claim 1, c h a r a c t e r i z e d i n t h a t said step of fabricating said detector elements (16) comprises the steps of:
   a) polishing said detector substrate (14) to a desired final thickness; and
   b) delineating individual detector arrays (16) from said detector substrate (14).

12. A method according to claim 1, c h a r a c t e r i z e d i n t h a t said detector substrate (14) comprises mercury cadmium telluride.

13. A method according to claim 1, c h a r a c t e r i z e d i n t h a t said detector substrate (14) comprises a pyroelectric material.

FIG. IA

FIG. IB

FIG. IC

FIG. ID

FIG. IE